# FASCICULE DE BREVET EUROPEEN

(11) **EP 2 893 788 B1**
(45) Date de publication et mention de la délivrance du brevet: **28.02.2018**
(21) Numéro de dépôt: 13759511.2
(22) Date de dépôt: 06.09.2013
(51) Int. Cl.: H05K 7/20

(54) **EQUIPEMENT ÉLECTRONIQUE À REFROIDISSEMENT PAR AIR ET DISPOSITIF DE REFROIDISSEMENT D'UN COMPOSANT ÉLECTRONIQUE**
LUFTGEKÜHLTE ELEKTRONISCHE VORRICHTUNG UND VORRICHTUNG ZUR KÜHLUNG EINES ELEKTRONISCHEN BAUSTEINS
AIR-COOLED ELECTRONIC EQUIPMENT AND DEVICE FOR COOLING AN ELECTRONIC COMPONENT

(30) Priorité: 06.09.2012 FR 1258361
(43) Date de publication de la demande: 15.07.2015
(73) Titulaire: SAGEMCOM BROADBAND SAS, 92500 Rueil Malmaison (FR)
(72) Inventeur: KOHN, Stéphane, 92500 Rueil-Malmaison (FR); LIEVEN, Hervé, 92500 Rueil-Malmaison (FR)
(74) Mandataire: Lavialle, Bruno François Stéphane
(86) Numéro de dépôt international: PCT/EP2013/068514
(87) Numéro de publication internationale: WO 2014/037530

(56) Documents cités:
- US-B1- 7 262 964

## Description

La présente invention concerne un équipement électronique à refroidissement par air et un dispositif de refroidissement pour composant électronique.

Un tel équipement électronique comporte une carte sur laquelle sont fixés des composants électroniques. Le refroidissement des composants électroniques ayant le fonctionnement le plus exothermique est assuré par un radiateur ayant des ailettes en saillie d'un fond reposant sur le composant électronique et l'équipement comprend des moyens de ventilation forcée comme un ventilateur et un guide d'air pour canaliser l'air provenant du ventilateur jusqu'au radiateur. Il est ainsi assuré un transfert de chaleur par conduction entre le composant électronique et le radiateur et un transfert de chaleur par convection entre le radiateur et l'air chargé d'évacuer les calories produites lors du fonctionnement de ces composants. Le document US B1 7 262 964 décrit un drain thermique fixé sur un composant électronique et recouvert par un capot formant un guide d'air. La fixation du radiateur est assurée par un collage au moyen d'un adhésif thermique ou par assemblage mécanique au moyen d'une épingle qui chevauche le radiateur et est clipée sur la carte pour appliquer le fond du radiateur sur le composant électronique. Le collage n'est pas toujours possible en raison de problème de compatibilité entre la colle et le matériau constituant le composant électronique. Cette incompatibilité peut conduire à la séparation du radiateur et du composant électronique. Le clipage de l'épingle peut donner lieu à des erreurs de montage qui pourraient compromettre son maintien sur le composant électronique et donc le refroidissement du composant électronique et le bon fonctionnement de l'équipement électronique en totalité.

Le manque de fiabilité de la fixation fait ainsi peser le risque d'une mauvaise qualité de contact entre le composant électronique et le radiateur qui limiterait le transfert de chaleur vers le radiateur et provoquerait un mauvais fonctionnement de l'équipement électronique.

Un objet de l'invention est donc de proposer un moyen pour améliorer la fiabilité de la fixation du radiateur sur le composant électronique.

A cet effet, on propose, selon l'invention, un équipement électronique comportant une carte pourvue d'un composant électronique, un radiateur ayant un fond surmonté d'ailettes, le fond du radiateur reposant sur le composant électronique, et un capot s'étendant par dessus le radiateur en ménageant une circulation d'air autour des ailettes du radiateur. Le capot comporte une pluralité de lames élastiques appliquées chacune sur un bord supérieur d'au moins une des ailettes pour maintenir le radiateur appliqué contre le composant et les lames élastiques ont une première extrémité solidaire du capot et une deuxième extrémité libre appliquée contre le bord supérieur des ailettes.

Ainsi, le radiateur est maintenu mécaniquement en place sur le composant électronique par le capot sans nécessité de rapporter en plus une épingle. Le risque d'un mauvais montage est donc limité.

Les lames élastiques sont appliquées indépendamment en au moins deux points du radiateur, ce qui permet :
- d'assurer une relative stabilité du radiateur ;
- ramener au moins en partie vers l'horizontale le radiateur si celui-ci est mal positionné ;
- d'avoir des deuxièmes extrémités soit à la même hauteur soit à des hauteurs différentes lorsque de radiateur a des ailettes de hauteurs différentes. Les lames ressort peuvent en outre être agencées pour exercer des contraintes identiques ou différentes sur le radiateur en jouant sur les raideurs.

De préférence, le capot a une forme de guide d'air et possède une extrémité dans laquelle est fixé un ventilateur.

L'invention a également pour objet un dispositif de refroidissement pour composant électronique, comprenant un radiateur ayant un fond surmonté d'ailettes, le fond du radiateur étant agencé pour reposer sur le composant électronique, et un capot agencé pour s'étendre par dessus le radiateur en ménageant une circulation d'air autour des ailettes du radiateur. Le capot comportant au moins une lame élastique agencée pour être appliquée sur un bord supérieur d'au moins une des ailettes de manière à maintenir le radiateur appliqué contre le composant et les lames élastiques ont une première extrémité solidaire du capot et une deuxième extrémité libre appliquée contre le bord supérieur des ailettes.

D'autres caractéristiques et avantages de l'invention ressortiront à la lecture de la description qui suit de modes de réalisation particuliers non limitatifs de l'invention.

Il sera fait référence aux dessins annexés, parmi lesquels :

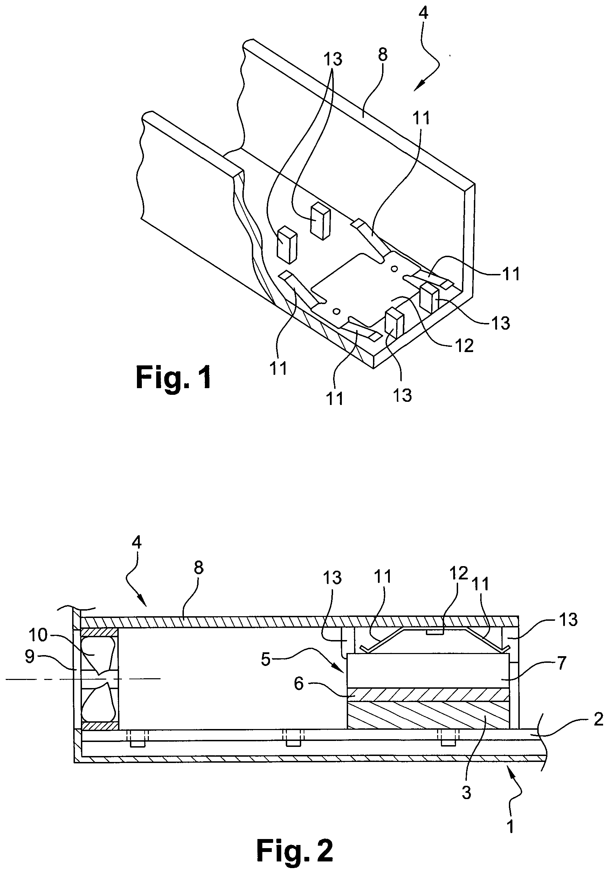

- la figure 1 est une vue partielle en perspective et avec écorché d'un capot d'un équipement conforme à l'invention,
- la figure 2 est une vue schématique partielle, en coupe, de l'équipement de l'invention.

En référence aux figures, l'équipement électronique selon l'invention comporte un boîtier extérieur, généralement désigné en 1, recevant une carte 2 pourvue d'un composant électronique 3, et un dispositif de refroidissement généralement désigné en 4.

Le dispositif de refroidissement 4 comprend un radiateur généralement désigné en 5 ayant un fond 6 surmonté d'ailettes 7. Le fond 6 du radiateur 5 repose sur la surface supérieure du composant électronique 3. Une couche de transfert thermique, adhésive ou non, à changement de phase ou non, peut être disposée entre le composant et le fond du radiateur pour assurer un meilleur transfert de chaleur entre le composant et le radiateur.

Le dispositif de refroidissement 4 comprend un capot 8 s'étendant par dessus le radiateur 5 en ménageant une circulation d'air autour des ailettes 7 du radiateur 5.

Le capot 8 est conformé en guide d'air s'étendant depuis une ouverture de ventilation 9 du boîtier 1 jusqu'au radiateur 5 et un ventilateur 10 est monté dans le capot 8 au voisinage de l'ouverture de ventilation 9. Le capot a une section transversale en U dont les bords libres sont pourvus de harpons engagés élastiquement dans des ouvertures de la carte 2. Le capot 8 est ainsi fixé directement sur la carte 2 et le ventilateur 10 est fixé dans l'extrémité du capot 8 s'étendant au voisinage de l'ouverture de ventilation 9.

Le capot 8 comporte des lames élastiques 11 appliquée sur un bord supérieur d'au moins une des ailettes 7 pour maintenir le radiateur 5 appliqué contre le composant électronique 3. Chaque lame élastique 11 a un plan médian parallèle aux plans des ailettes 7 et a ici une largeur supérieure à un espacement des ailettes 7 de sorte que chaque lame élastique 11 prend appui sur au moins une ailette 7 et, de préférence, deux ailettes 7 adjacentes. Les lames élastiques 7 ont une extrémité solidaire d'une pièce support 12 rapportée dans le capot et une extrémité libre et appliquée contre le bord supérieur des ailettes 7. La pièce support 12 est fixée sur l'âme du capot 8 par déformation thermoplastique (écrasement) de plots qui s'étendent en saillie de l'âme et sont engagés dans des orifices de la pièce support 12. Les lames élastiques 11, au repos (c'est-à-dire avant mise en place du capot par-dessus le radiateur), ont un angle ici compris entre 20° et 45° par rapport à la pièce support 12. Les lames élastiques 11 en position de repos laissent dans le capot 8 un espace ayant une hauteur inférieur à la hauteur de l'ensemble composant électronique 3 et radiateur 5. Les ailettes 11 sont ici au nombre de quatre et ont des extrémités libres disposées aux sommets d'un parallélogramme. Lorsque le capot 8 est en place et les lames élastiques 11 sont appliquées contre le radiateur 5, les lames élastiques 11 sont déformées élastiquement de sorte que l'angle en question est réduit et les lames élastiques 11 tendent à revenir à leur position initiale en exerçant un effort sur le radiateur 5 qui tend à l'appliquer sur le composant électronique 3. L'extrémité libre des lames élastiques 11 est recourbée vers le haut pour réduire le frottement des lames élastiques 11 contre les ailettes 7 du radiateur 5 lors de la mise en place du capot 8.

Le capot 8 est en outre pourvu intérieurement de reliefs de positionnement 13 agencés pour être engagés entre deux ailettes 7 du radiateur 5. Les reliefs de positionnement 13 s'étendent en saillie de l'âme du capot 8 et ont pour fonction d'assurer un positionnement latéral du radiateur 5 en cas de défaillance des lames élastiques 11.

Lorsque les lames élastiques sont en matériau thermiquement conducteur, il y a un transfert thermique entre le radiateur et les lames élastiques. Les lames élastiques se comportent alors, en particulier lorsque la température ambiante est élevée (40°C par exemple), comme un radiateur additionnel favorisant le refroidissement du composant.

Bien entendu, l'invention n'est pas limitée aux modes de réalisation décrits mais englobe toute variante entrant dans le champ de l'invention telle que définie par les revendications.

En particulier, les lames élastiques peuvent avoir une structure différente de celle décrite. Chaque lame élastique peut ainsi être de forme incurvée avec ses deux extrémités fixées au capot à la manière d'une lame ressort pour prendre appui sur le radiateur par sa portion centrale incurvée.

Les lames élastiques peuvent être des lames individuelles ou solidaires d'une même pièce support. Les lames peuvent être fixées par tout moyen tel que boutrolage, collage, soudage, surmoulage...

Les lames élastiques peuvent avoir une largeur inférieure à l'espacement entre les ailettes mais le positionnement relatif du radiateur et des lamelles doit être précis pour être sûr que chaque lamelle est en appui sur une ailette et ne se trouve pas entre deux ailettes.

Les lames élastiques peuvent être au nombre de deux ou plus et par exemple trois ou six. Les lames élastiques peuvent avoir des raideurs différentes (en étant de longueurs, de formes et/ou de matériaux différents)

L'invention est applicable à tout type d'équipement électronique.

L'invention s'applique tant à des moyens de refroidissement naturel que forcé.

Le capot peut être constitué par une partie du boîtier de l'équipement qui n'assure pas elle-même de fonction de refroidissement.

Le capot peut être fixé sur un châssis entourant et servant de support à la carte électronique. Le capot forme ainsi le boîtier de l'équipement et peut être agencé pour former également un guide d'air.

Les quatre reliefs de positionnement 13 sont ici disposés sensiblement à l'extérieur des lames élastiques 11 selon la direction longitudinale du capot 8. En variante, les reliefs de positionnement 13 peuvent être positionnés entre les lames élastiques 11. Leur nombre peut également être modifié.

## Revendications

1. Equipement électronique comportant une carte (2) pourvue d'un composant électronique (3), un radiateur (5) ayant un fond (6) surmonté d'ailettes (7), le fond du radiateur reposant sur le composant électronique et un capot (8) s'étendant par dessus le radiateur en ménageant une circulation d'air autour des ailettes du radiateur, le capot comportant une pluralité de lames élastiques (11) appliquée chacune sur un bord supérieur d'au moins une des ailettes pour maintenir le radiateur appliqué contre le composant et les lames élastiques (11) ont une première extrémité solidaire du capot et une deuxième extrémité libre appliquée contre le bord supérieur des ailettes.

2. Equipement selon la revendication 1, comportant un boîtier extérieur (1) pourvu d'une ouverture de ventilation (9), le capot (8) étant un guide d'air s'étendant depuis cette ouverture de ventilation jusqu'au radiateur (5) et un ventilateur (10) étant monté dans le capot au voisinage de l'ouverture de ventilation.

3. Equipement selon la revendication 2, dans lequel le capot (8) est fixé directement sur la carte (2).

4. Equipement selon la revendication 1, dans lequel la lame élastique (11) a une largeur supérieure à un espacement des ailettes (7).

5. Equipement selon la revendication 1, dans lequel la première extrémité des lames élastiques (11) est solidaire d'une pièce support (12) rapportée dans le capot.

6. Equipement selon la revendication 1, dans lequel le capot (8) est pourvu d'au moins un relief de positionnement (13) agencé pour être engagé entre deux ailettes (7) du radiateur (5).

7. Equipement selon la revendication 1, dans lequel les deuxièmes extrémités des lames élastiques (11) sont au moins au nombre de quatre, disposées aux sommets d'un parallélogramme.

8. Dispositif de refroidissement pour composant électronique, comprenant un radiateur (5) ayant un fond (6) surmonté d'ailettes (7), le fond du radiateur étant agencé pour reposer sur le composant électronique (3), et un capot (8) agencé pour s'étendre par dessus le radiateur en ménageant une circulation d'air autour des ailettes du radiateur, le capot comportant des lames élastiques (11) agencées pour être appliquées chacune sur un bord supérieur d'au moins une des ailettes de manière à maintenir le radiateur appliqué contre le composant, les lames élastiques (11) ayant une première extrémité solidaire du capot et une deuxième extrémité libre appliquée contre le bord supérieur des ailettes (7) du radiateur (5).

9. Dispositif selon la revendication 8, dans lequel le capot (8) a une forme de guide d'air et possède une extrémité dans laquelle est fixé un ventilateur (10).

10. Dispositif selon la revendication 8, dans lequel la lame élastique (11) a une largeur supérieure à un espacement des ailettes (7).

11. Dispositif selon la revendication 8, dans lequel la première extrémité des lames élastiques est solidaire d'une pièce de support (12) rapportée dans le capot.

12. Dispositif selon la revendication 8, dans lequel le capot (8) est pourvu d'au moins un relief de positionnement (13) agencé pour être engagé entre deux ailettes (7) du radiateur (5).

13. Dispositif de refroidissement selon la revendication 8, dans lequel les lames élastiques (11) au repos (avant application contre le radiateur) ont un angle compris entre 20° et 45° par rapport à la pièce support (12).

14. Dispositif selon la revendication 8, dans lequel l'extrémité libre des lames (11) est recourbée vers le capot.

## Patentansprüche

1. Elektronisches Gerät, umfassend eine Karte (2), die mit einem elektronischen Bauelement (3) versehen ist, einen Radiator (5), der einen Boden (6) hat, über dem Rippen (7) angeordnet sind, wobei der Boden des Radiators auf dem elektronischen Bauelement aufliegt, sowie eine Abdeckung (8), die sich über dem Radiator erstreckt und dabei eine Luftzirkulation um die Rippen des Radiators herum erzeugt, wobei die Abdeckung eine Vielzahl von elastischen Zungen (11) umfasst, die jeweils auf einem oberen Rand mindestens einer der Rippen aufliegen, um den Radiator in Anlage an dem Bauelement zu halten, und die elastischen Zungen (11) ein erstes Ende haben, das fest mit der Abdeckung verbunden ist, sowie ein freies zweites Ende, das an dem oberen Rand der Rippen anliegt.

2. Gerät nach Anspruch 1, umfassend ein äußeres Gehäuse (1), das mit einer Lüftungsöffnung (9) versehen ist, wobei die Abdeckung (8) eine Luftführung ist, die sich ab dieser Lüftungsöffnung bis zum Radiator (5) erstreckt, und wobei ein Ventilator (10) in der Abdeckung nahe der Lüftungsöffnung angebracht ist.

3. Gerät nach Anspruch 2, bei dem die Abdeckung (8) direkt auf der Karte (2) befestigt ist.

4. Gerät nach Anspruch 1, bei dem die elastische Zunge (11) eine Breite hat, die größer als ein Abstand der Rippen (7) ist.

5. Gerät nach Anspruch 1, bei dem das erste Ende der elastischen Zungen (11) fest mit einem Trägerteil (12) verbunden ist, das in der Abdeckung befestigt ist.

6. Gerät nach Anspruch 1, bei dem die Abdeckung (8) mit mindestens einer Positioniererhebung (13) versehen ist, die so ausgebildet ist, dass sie zwischen zwei Rippen (7) des Radiators (5) eingeführt wird.

7. Gerät nach Anspruch 1, bei dem die zweiten Enden der elastischen Zungen (11) mindestens vier an der Zahl sind, die an den Eckpunkten eines Parallelogramms angeordnet sind.

8. Kühlvorrichtung für ein elektronische Bauelement, umfassend einen Radiator (5), der einen Boden (6) hat, über dem Rippen (7) angeordnet sind, wobei der Boden des Radiators so ausgebildet ist, dass er auf dem elektronischen Bauelement (3) aufliegt, sowie eine Abdeckung (8), die so ausgebildet ist, dass sie sich über dem Radiator erstreckt und dabei eine Luftzirkulation um die Rippen des Radiators herum erzeugt, wobei die Abdeckung elastische Zungen (11) umfasst, die so ausgebildet sind, dass sie jeweils auf einem oberen Rand mindestens einer der Rippen aufliegen, derart, dass sie den Radiator in Anlage an dem Bauelement halten, wobei die elastischen Zungen (11) ein erstes Ende haben, das fest mit der Abdeckung verbunden ist, sowie ein freies zweites Ende, das an dem oberen Rand der Rippen (7) des Radiators (5) anliegt.

9. Vorrichtung nach Anspruch 8, bei der die Abdeckung (8) eine Luftführungsform hat und ein Ende besitzt, in dem ein Ventilator (10) befestigt ist.

10. Vorrichtung nach Anspruch 8, bei der die elastische Zunge (11) eine Breite hat, die größer als ein Zwischenraum der Rippen (7) ist.

11. Vorrichtung nach Anspruch 8, bei der das erste Ende der elastischen Zungen fest mit einem Trägerteil (12) verbunden ist, das in der Abdeckung befestigt ist.

12. Vorrichtung nach Anspruch 8, bei der die Abdeckung (8) mit mindestens einer Positioniererhebung (13) versehen ist, die so ausgebildet ist, dass sie zwischen zwei Rippen (7) des Radiators (5) eingeführt wird.

13. Kühlvorrichtung nach Anspruch 8, bei der die elastischen Zungen (11) in Ruhestellung (vor der Anlage an dem Radiator) einen Winkel zwischen 20° und 45° in Bezug auf das Trägerteil (12) haben.

14. Vorrichtung nach Anspruch 8, bei der das freie Ende der Zungen (11) in Richtung der Abdeckung umgebogen ist.

## Claims

1. Electronic equipment comprising a card (2) having an electronic component (3), a radiator (5) having a bottom (6) carrying fins (7), the bottom of the radiator resting on the electronic component, and the equipment also having a cover (8) extending over the radiator and arranging for air to flow around the fins of the radiator, the cover including a plurality of spring blades (11), each pressed against a top edge of at least one of the fins in order to hold the radiator pressed against the component, and the spring blades (11) have respective first ends that are secured to the cover and respective second ends that are free and pressed against the top edge of the fins.

2. Equipment according to claim 1, comprising an outer housing (1) including a ventilation opening (9), the cover (8) being a guide for air that extends from the ventilation opening to the radiator (5), a fan (10) being mounted in the cover in the vicinity of the ventilation opening.

3. Equipment according to claim 2, wherein the cover (8) is fastened directly to the card (2).

4. Equipment according to claim 1, wherein the spring blade (11) is of width that is greater than spacing between the fins (7).

5. Equipment according to claim 1, wherein the first end of each spring blade (11) is secured to a support part (12) fitted in the cover.

6. Equipment according to claim 1, wherein the cover (8) is provided with at least one positioning portion in relief (13) arranged to be engaged between two fins (7) of the radiator (5).

7. Equipment according to claim 1, wherein the second ends of the spring blades (11) are at least four in number, being arranged at the vertices of a parallelogram.

8. A cooler device for an electronic component, the device comprising a radiator (5) having a bottom (6) carrying fins (7), the bottom of the radiator being arranged to rest on the electronic component (3), and the device also having a cover (8) arranged to extend over the radiator so as to provide a flow of air around the fins of the radiator, the cover including spring blades (11), each arranged to press against a top edge of at least one of the fins so as to hold the radiator pressed against the component, each spring blade (11) having a first end that is secured to the cover and a second end that is free and pressed against the top edge of the fins (7) of the radiator (5).

9. A device according to claim 8, wherein the cover (8) forms a guide for air and possesses an end in which a fan (10) is fastened.

10. A device according to claim 8, wherein the spring blade (11) is of width that is greater than spacing between the fins (7).

11. A device according to claim 8, wherein the first ends of the spring blades are secured to a support part (12) fitted in the cover.

12. A device according to claim 8, wherein the cover (8) is provided with at least one positioning portion in relief (13) arranged to be engaged between two fins (7) of the radiator (5).

13. A cooler device according to claim 8, wherein, at rest (i.e. before being pressed against the radiator), the spring blades (11) extend at an angle lying in the range 20° to 45° relative to the support part (12).

14. A device according to claim 8, wherein the free ends of the blades (11) are curved towards the cover.
